# EUROPÄISCHE PATENTSCHRIFT

(11) **EP 2 815 430 B1**
(45) Veröffentlichungstag und Bekanntmachung des Hinweises auf die Patenterteilung: **21.11.2018**
(21) Anmeldenummer: 13702607.6
(22) Anmeldetag: 25.01.2013
(51) Int. Cl.: H01L 27/02, H01L 29/739, H01L 29/78, H01L 29/06, H01L 29/10, G01H 5/00, G01N 29/07, G01N 29/44, G01N 29/46, G01S 7/53, G01S 15/10

(54) **HALBLEITERANORDNUNG FÜR EINEN STROMSENSOR IN EINEM LEISTUNGSHALBLEITER**
SEMICONDUCTOR ARRANGEMENT FOR A CURRENT SENSOR IN A POWER SEMICONDUCTOR
ENSEMBLE À SEMI-CONDUCTEURS D'UN CAPTEUR DE COURANT DISPOSÉ DANS UN SEMI-CONDUCTEUR DE PUISSANCE

(30) Priorität: 14.02.2012 DE 102012202180
(43) Veröffentlichungstag der Anmeldung: 24.12.2014
(73) Patentinhaber: Robert Bosch GmbH, 70442 Stuttgart (DE); Infineon Technologies AG, 85579 Neubiberg (DE)
(72) Erfinder: JACKE, Thomas, 72070 Tuebingen (DE); HOEHR, Timm, 72762 Reutlingen (DE); PLUNTKE, Christian, 72379 Hechingen (DE)
(74) Vertreter: Gulde & Partner
(86) Internationale Anmeldenummer: PCT/EP2013/051415
(87) Internationale Veröffentlichungsnummer: WO 2013/120680

(56) Entgegenhaltungen:
- WO-A1-2011/161721
- JP-A- 2007 287 988
- US-A1- 2005 286 194
- US-A1- 2008 230 810
- US-A1- 2010 320 461
- US-B1- 6 180 966

## Beschreibung

Die Erfindung betrifft eine Halbleiteranordnung für einen Stromsensor in einem Leistungshalbleiter, insbesondere für einen Leistungshalbleiter vom Typ eines Bipolartransistors mit isolierter Gate-Elektrode auch Insulated Gate Bipolar Transistor (IGBT) genannt.

### Stand der Technik

Leistungshalbleiter werden üblicherweise als vertikale Struktur gefertigt und weisen eine Vielzahl von Transistor-Zellen auf. Dabei werden auf der Vorderseite eines Halbleitersubstrats Gate- und Emitterstrukturen gebildet, die über mindestens einen p-n-Übergang mit der auf der Rückseite als vollflächige Metallisierung ausgebildeten Kollektorschicht verbunden sind. Bei Leistungstransistoren wiederholt sich diese Zellenstruktur über einen großen Bereich des Substrats, so dass hohe Ströme geschaltet werden können. Dabei ist jedoch zu beachten, dass Kurzschluss- oder Überlastzustände vermieden werden. So ist es aus dem allgemeinen Stand der Technik bekannt, am Ausgangsanschluss einen Shunt-Widerstand anzubringen, um eventuell auftretende Kurzschlüsse oder Überlastzustände im Hauptstromkreis zu detektieren.

Weiterhin ist es Stand der Technik, einen Bereich des Emitters bzw. einen Teil der Emitterzellen über einen Sensoranschluss abzuzweigen und den dort fließenden Strom als Signal zu nutzen. Typischerweise liegt der Sensoranschluss innerhalb des Emittergebiets und ist vollständig oder teilweise mit Emitterzellen gefüllt. Im Fall der vollständigen Füllung ist die Einbettung der Sensorzellen in den Hauptemitter sehr eng und es ist zu erwarten, dass das Verhalten der Sensorzellen nur wenig von dem der Hauptemitterzellen abweicht. Aber durch das Größenverhältnis von Emitteranschluss und Sensoranschluss ist ein festes Verhältnis von Sensorstrom zu Hauptstrom vorgegeben. Der Fall der nur teilweisen Füllung bietet den Vorteil, dieses Verhältnis freier zu gestalten, aber dafür geht die enge Einbettung verloren und gibt es zellfreie Bereiche, in denen sich im leitenden Zustand ebenfalls ein Ladungsträgerplasma aufbaut.

Bei der Verwendung bzw. schon beim Design eines IGBTs ist zu beachten, dass die im Abschaltfall durch den Emitter abfließenden Ladungsträger die einzelnen Transistorzellen nicht überlasten. Im Beispiel eines IGBTs mit n-Kanal ist die durch den Emitter abfließende Ladungsträgerspezies durch Löcher gegeben. Die Gefahr der Überlastung und das Auslösen eines Latch-up besteht speziell für die an den Rändern des Sensebereichs und des Hauptemitterbereichs befindlichen Zellen, da sich auch in den zellfreien Bereichen ohne Emitterkontakte ein Ladungsträgerplasma ausbildet. Dieser keine Zellen enthaltende Zwischenbereich (zellfreies Gebiet) existiert zum einen bei unvollständiger Füllung des Sensoranschlusses, er resultiert aber auch aus der Notwendigkeit, die mit den beiden Emitterbereichen verbundenen leitenden Schichten zu trennen. US 2009/0250770 A1 ist mit der Integration eines Sensor-FET in einen diskreten Leistungs-MOSFET befasst. Weiterer Stand der Technik ist in JP2007-287988 A beschrieben.

### Offenbarung der Erfindung

Die Aufgabe der Erfindung ist, die Belastung der an zellfreie Gebiete grenzenden Zellen durch die beim Abschalten abfließenden Löcher des in den zellfreien Gebieten befindlichen Ladungsträgerplasmas zu reduzieren und zugleich eine möglichst enge Einbettung der Sensorzellen in den Hauptemitter zu ermöglichen.

Diese Aufgabe wird durch eine Schaltungsanordnung für einen Leistungshalbleiter gelöst, die auf einem Substrat eine Mehrfachanordnung von Transistorzellen mit isolierter Gate-Elektrode umfasst, deren Emitteranschlüsse in einem ersten Bereich über eine erste leitfähige Schicht mit wenigstens einem Ausgangsanschluss verbunden sind und deren Emitteranschlüsse in einem zweiten Bereich über eine zweite leitfähige Schicht mit wenigstens einem Sensoranschluss verbunden sind. Der Sensoranschluss ist außerhalb einer ersten Zellengebietsgrenze angeordnet, die die Transistorzellen des ersten Bereichs und die Transistorzellen des zweiten Bereichs umschließt. Zwischen den Transistorzellen des zweiten Bereichs und dem Sensoranschluss ist eine zur ersten Zellengebietsgrenze gehörende Grabenstruktur ausgebildet, an die sich in Richtung zu einem Außenrand des Substrats eine mit der ersten leitfähigen Schicht verbundene dotierte Schicht anschließt und die sich darüber hinaus zwischen den Transistorzellen des ersten Bereichs und den Transistorzellen des zweiten Bereichs fortsetzt. Die dotierte Schicht ist dabei unter dem Sensoranschluss angeordnet.

Gemäß der Erfindung wird der aus den IGBT-Zellen bestehende Emitter in zwei Zellgruppen unterteilt. Zum einen werden Hauptzellen gebildet, die mittels der ersten leitfähigen Schicht mit dem Emitterausgang verbunden sind. Diese Zellgruppe belegt den größten Teil der Substratfläche der Schaltungsanordnung. Der mit der zweiten leitfähigen Schicht verbundene, kleinere Teil wird als Sensorzellen bereitgestellt, und dient als Stromsensor, so dass über einen externen Widerstand ein Spannungssignal erzeugt werden kann, das zur Detektion von Kurzschluss- und Überströmen weiterverarbeitet werden kann. Das an die erste leitfähige Schicht angeschlossene dotierte Gebiet dient zum Ableiten der beim Abschaltvorgang abfließenden Löcher, so dass diese die angrenzenden Hauptzellen nicht belasten, was zu einer erhöhten Gefahr von Latch-Ereignissen und damit zur Zerstörung des Chips führen könnte.

Die Aufgabe der Erfindung wird dadurch gelöst, dass der Anschluss des Sensors außerhalb des aktiven Zellengebiets hinter der Zellengebietsgrenze so platziert wird, dass das dotierte Gebiet über dem Sensoranschluss angeordnet ist. Die aus diesem Anschlussbereich stammenden Löcher werden über das an die leitende Schicht des Hauptemitters angeschlossenes, dotiertes Gebiet abgeführt. Damit können zudem Größe und Form des Sensorgebietes unabhängig von der Größe und Form des Sensoranschlusses gestaltet werden.

Gemäß einer weiteren Ausgestaltung der Erfindung sind die Transistorzellen des zweiten Bereichs in Form eines beliebigen Polygons, vorzugsweise in Form eines Halbkreises, oder eines einen Halbkreis annähernden Polygons, oder eines Rechtecks oder eines Quadrats, angeordnet.

Diese Anordnungen können mit den üblichen Layoutprogrammen auf einfache Weise als sich wiederholende Struktur gebildet werden und sind mit den gängigen Herstellungsprozessen der Leistungshalbleiter realisierbar.

Gemäß einer weiteren Ausgestaltung der Erfindung umschließen die Transistorzellen des ersten Bereichs die Transistorzellen des zweiten Bereichs wenigstens teilweise, vorzugsweise an drei Seiten.

Gemäß einer weiteren Ausgestaltung der Erfindung umschließen die Transistorzellen des ersten Bereichs die Transistorzellen des zweiten Bereichs vollständig.

Gemäß einer weiteren Ausgestaltung der Erfindung sind die Transistorzellen des zweiten Bereichs von den Transistorzellen des ersten Bereichs räumlich getrennt angeordnet.

In dieser Ausführungsform werden die Stromsensorzellen nicht eng in die Haupt-Zellen eingebettet, sondern weit von diesen entfernt mit einer eigenen Zellengebietsgrenze umgeben. Dies entspricht einem abgetrennten kleineren IGBT-Halbleiter, dessen Plasma im eingeschalteten Zustand bzw. während der Schaltvorgänge je nach Entfernung wenig bis gar nicht mit dem des Haupt-IGBTs wechselwirkt. Dennoch sind beide Teile immer noch als ein IGBT-Chip zu betrachten, da sie in Richtung auf den Rand des Chips von einer gemeinsamen Randabschlussstruktur umgeben sind.

Gemäß einer weiteren Ausgestaltung der Erfindung ist der Sensoranschluss als Metallisierungsfläche über einer Isolationsschicht angeordnet ist, deren Schichtdicke größer als die eines Gate-Dielektrikums ist.

In dieser Ausführungsform lässt sich der Sensoranschluss an beliebiger Stelle über einem Dickoxid platzieren.

Gemäß einer weiteren Ausgestaltung der Erfindung sind die Transistorzellen des zweiten Bereichs von einer zweiten Zellengebietsgrenze umgeben.

Diese Ausführungsform wird insbesondere dann angewendet, wenn die Sensorzellen weit weg von den Hauptzellen angeordnet sind.

Die zweite leitfähige Schicht kann im Bereich der Zellengebietsgrenze eine Einkerbung aufweisen, in der die erste leitfähige Schicht mit der dotierten Schicht verbunden ist. Dies führt zu einer weiteren Verbesserung des Ableitens der beim Abschaltvorgang abfließenden Löcher.

Die Erfindung wird nachfolgend anhand von Ausführungsbeispielen unter Bezugnahme auf die anhängenden Zeichnungen näher erläutert.

In den Zeichnungen zeigen:
Fig. 1 Transistorzellen in einer Querschnittsansicht;
Fig. 2a eine erfindungsgemäße Halbleiteranordnung in einer Draufsicht gemäß einer ersten Ausführungsform der Erfindung;
Fig. 2b eine erfindungsgemäße Halbleiteranordnung in einer weiteren Draufsicht gemäß der ersten Ausführungsform der Erfindung;
Fig. 3 eine weitere schematische Darstellung der Ausführungsform gemäß Fig. 2a;
Fig. 4 eine erfindungsgemäße Halbleiteranordnung in einer Draufsicht gemäß einer weiteren Ausführungsform der Erfindung;
Fig. 5 eine erfindungsgemäße Halbleiteranordnung in einer Draufsicht gemäß einer weiteren Ausführungsform der Erfindung;
Fig. 6 eine erfindungsgemäße Halbleiteranordnung in einer Draufsicht gemäß einer weiteren Ausführungsform der Erfindung;
Fig. 7 eine erfindungsgemäße Halbleiteranordnung in einer Draufsicht gemäß einer weiteren Ausführungsform der Erfindung, und
Fig. 8 eine erfindungsgemäße Halbleiteranordnung in einer Draufsicht gemäß einer weiteren Ausführungsform der Erfindung.

In den Zeichnungen werden gleiche bzw. gleich wirkende Elemente mit identischen Bezugszeichen versehen.

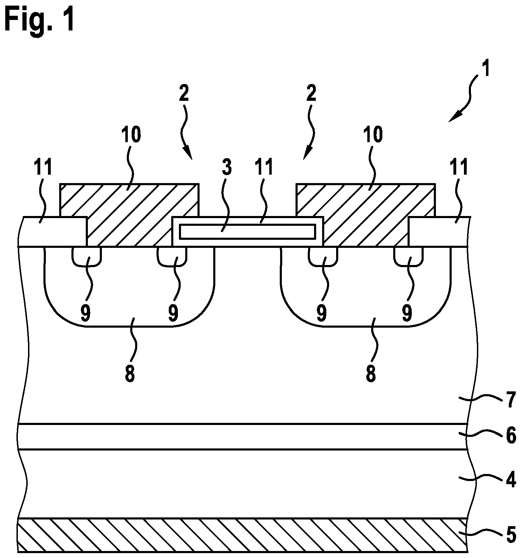

In Fig. 1 ist ein Ausschnitt einer Schaltungsanordnung 1 gezeigt, die eine Basiszelle für eine Vielzahl von Transistorzellen 2 mit isolierter Gate-Elektrode 3 (IGBT) darstellt. Wie aus Fig. 1 hervorgeht, umfasst ein Substrat 4, das beispielsweise p+ dotiert ist, auf einer Rückseite einen Kollektoranschluss 5, der üblicherweise als Metallschicht aufgebracht ist. Über dem Kollektoranschluss 5 und dem Substrat 4 ist eine in diesem Beispiel n-dotierte Pufferschicht 6 aufgebracht auf die eine ebenfalls n-dotierte Epitaxieschicht 7 folgt. In die Epitaxieschicht 7 sind p-dotierte Wannen 8 beispielsweise durch Ionen-Implantation angeordnet, in denen jeweils zwei n-dotierte Inseln 9 angeordnet sind, die zusammen mit der p-dotierte Wanne 8 teilweise von einem Emitteranschluss 10 bedeckt sind.

Die Gate-Elektrode 3 ist von einer aus Siliziumoxid gebildeten Isolationsschicht 11 umgeben, die auch außerhalb der Transistorzelle 2 angeordnet sein kann. Insgesamt erhält man im gezeigten Beispiel eine n⁺pnp⁺-Struktur für einen n-Kanal-IGBT. Es ist jedoch auch denkbar, die Erfindung bei anderen IGBT Typen, beispielsweise einem p-Kanal-IGBT oder einem IGBT mit vertikaler Struktur, anzuwenden.

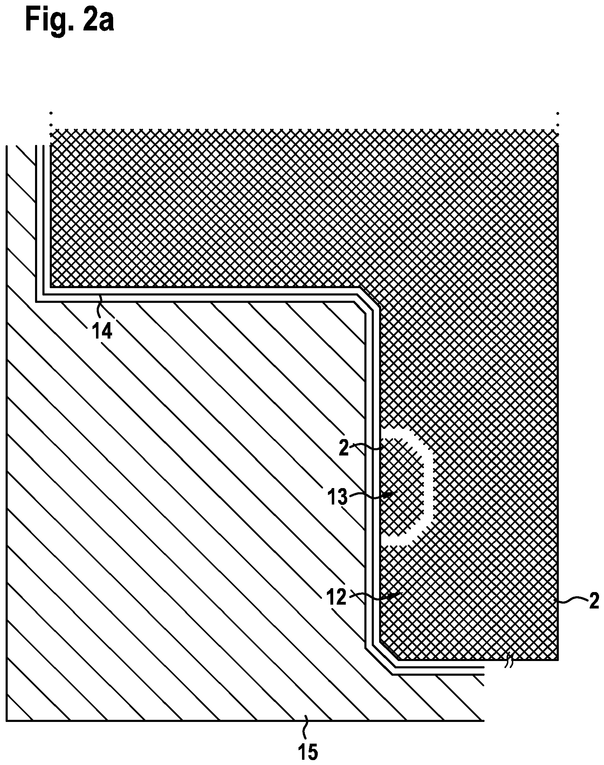

Im Folgenden wird die Schaltungsanordnung 1 gemäß einer ersten Ausführungsform der Erfindung beschrieben. In Fig. 2a ist die Schaltungsanordnung 1 in einer Draufsicht, d.h. auf die Oberseite mit den Emitteranschlüssen 10 gezeigt. Wie Fig. 2a zu entnehmen ist, umfasst die Schaltungsanordnung 1 eine Vielzahl von Transistorzellen 2, die in einem ersten Bereich 12 und in einem zweiten Bereich 13 angeordnet sind. Die in Fig. 2a gezeigte Anordnung ist dabei lediglich beispielhaft zu verstehen.

Die Transistorzellen 2 bedecken den ersten Bereich 12 bzw. den zweiten Bereich 13 im Wesentlichen vollständig und können in einem beliebigen Muster angeordnet werden, das nicht notwendigerweise regelmäßig sein muss. Die Transistor-zellen 2 des ersten Bereichs 12 sind parallel geschaltet und werden für den Leistungshalbleiter verwendet.
Transistorzellen 2 des zweiten Bereichs 13 sind ebenfalls parallel geschaltet und werden für einen Stromsensor herangezogen, wie weiter unten noch näher erläutert wird. Die Transistorzellen 2 des ersten Bereichs 12 können Hauptzellen genannt und die des zweiten Bereichs 13 als Sensorzellen bezeichnet werden.

Die Transistorzellen 2 des ersten Bereichs 12 und die Transistorzellen 2 des zweiten Bereichs 13 sind von einer ersten Zellengebietsgrenze umgeben, wobei Zellengebietsgrenze mit dem Bezugszeichen 14 versehen ist. Die erste Zellengebietsgrenze 14 ist in Form eines Grabens im Substrat ausgebildet. Es ist aber auch möglich, eine Doppelgrabenstruktur, die aus zwei nebeneinander laufenden Gräben im Substrat gebildet ist, zu verwenden. Das Gebiet außerhalb der ersten Zellengebietsgrenze 14 ist mit einer dotierten Schicht 15 versehen, die in dem gezeigten Ausführungsbeispiel eine p-dotierte Schicht ist. Die dotierte Schicht 15 ist in Fig. 2a als schraffierte Fläche eingezeichnet.

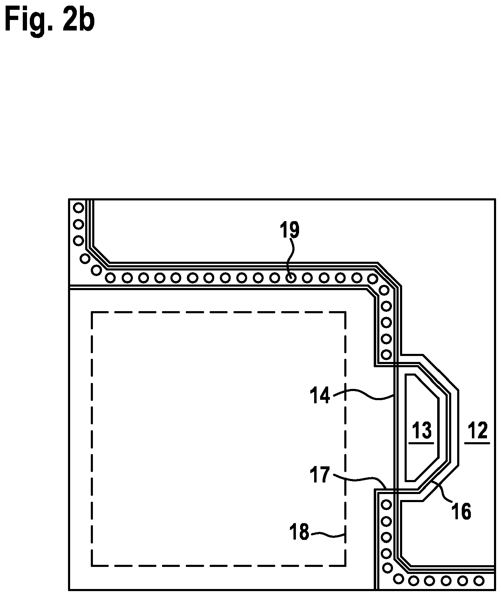

Unter Bezugnahme auf Fig. 2b wird im Folgenden die Kontaktierung der Transistorzellen 2 des ersten Bereichs 12 und der Transistorzellen 2 des zweiten Bereichs 13 näher erläutert. Die Kontaktierung erfolgt über Metallisierungsschichten, die die Emitteranschlüsse 10 gemäß Fig. 1 verbinden. In Fig. 2b sind zur besseren Darstellbarkeit die Transistorzellen 2 des ersten Bereichs 12 und die Transistorzellen 2 des zweiten Bereichs 13 sowie die p-dotierte Schicht 15 nicht eingezeichnet.

Die Emitteranschlüsse der Transistorzellen 2 des ersten Bereichs 12 sind über eine erste leitfähige Schicht 16 verbunden. Die erste leitfähige Schicht 16 kann über geeignete Ausgangsanschlüsse als Ausgang des Leistungstransistors dienen, in dem die Ausgänge der Transistorzellen 2 des ersten Bereichs 12 bereitgestellt werden.

Die Emitteranschlüsse 10 der Transistorzellen 2 des zweiten Bereichs 13 sind über eine zweite leitfähige Schicht 17 mit wenigstens einem Sensoranschluss verbunden. Der Sensoranschluss kann über einen Bond-Draht mit einem externen Widerstand verbunden werden, wie weiter unten erläutert wird. Die zweite leitfähige Schicht 17 fungiert auch als Sensoranschluss. Der Sensoranschluss ist in Fig. 1 schematisch durch das Bezugszeichen 18 angedeutet. Auf diese Weise wird zwischen den Emitteranschlüssen der Transistorzellen 2 des zweiten Bereichs 13 und dem Sensoranschluss 18 eine elektrische Verbindung hergestellt. Wie Fig. 2b zu entnehmen ist, klafft zwischen der ersten leitfähigen Schicht 16 und der zweiten leitfähigen Schicht 17 eine Lücke, so dass die Emitteranschlüsse dieser Bereiche nicht miteinander verbunden sind.

Wie bereits in Zusammenhang mit Fig. 2a erläutert, befindet sich unterhalb des Sensoranschlusses 18 die p-dotierte Schicht 15, die an einem Außenrand der ersten Randstruktur 14 angeordnet ist. Dieses Gebiet wird über die Kontakte 19 mit der ersten leitfähigen Schicht 16 verbunden. Folglich kann die p-dotierte Schicht 15 ein Ableiten der beim Abschaltvorgang abfließenden Löcher ermöglichen, so dass diese die benachbarten Zellen der Transistorzellen 2 des ersten Bereichs 12 nicht belasten.

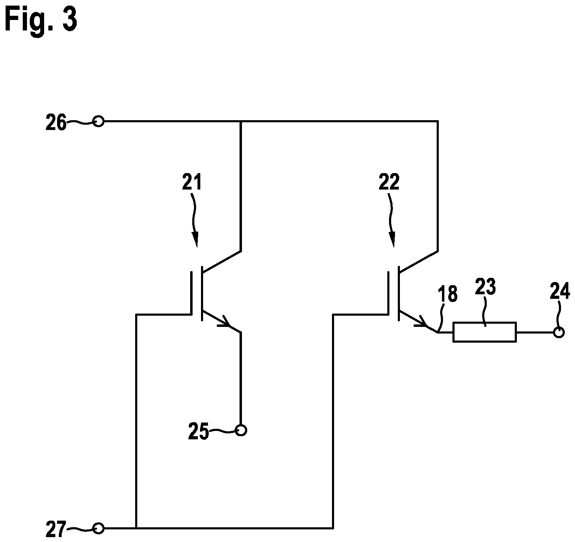

In Fig. 3 wird die Schaltungsanordnung 1 gemäß Fig. 1, Fig. 2a und 2b nochmals schematisch zusammengefasst. Die Transistorzellen 2 des ersten Bereichs 12 bilden den Hauptzellen-IGBT 21. Die Transistorzellen 2 des zweiten Bereichs 13 bilden den Sensorzellen-IGBT 22. Die jeweiligen Kollektoranschlüsse der beiden IGBTs können mit einem Anschluss 26 verbunden werden, die der Gateanschlüsse mit dem weiteren Anschluss 27. Der Emitteranschluss 10 des Hauptzellen-IGBT 21 ist mit dem Ausgangsanschluss 25 verbunden. Der Emitteranschluss 10 des Sensorzellen-IGBT 22 ist über den Sensoranschluss 18 mit einem Bauelement, das beispielsweise ein externer ohmscher Widerstand 23 sein kann, verbunden, wobei über das Signal 24 ein Kurzschluss- oder ein Überlastzustand an dem Ausgangsanschluss 25 detektiert werden kann.

Im Folgenden werden weitere Ausführungsformen der Erfindung beschrieben. Dabei werden im Wesentlichen die Unterschiede zu dem in Zusammenhang mit Fig. 2 gezeigten Ausführungsbeispiel dargelegt.

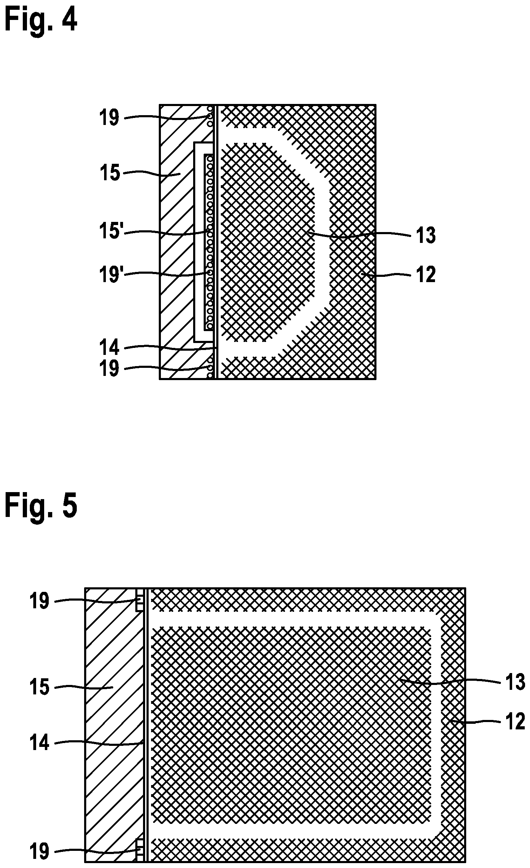

In Fig. 4 ist neben den Transistorzellen 2 des zweiten Bereichs 13 in Richtung des Sensoranschluss 18 ein weiterer p-dotierter Bereich 15' angeordnet, der von dem p-dotierten Bereich 15 abgetrennt ist. Der weitere p-dotierte Bereich 15' ist über weitere Kontakte 19' mit der zweiten leitfähigen Schicht 17 (nicht in Fig. 4 gezeigt) verbunden.

In Fig. 5 ist eine Variante der Anordnung der Transistorzellen 2 des zweiten Bereichs 13 gezeigt. Die Transistorzellen 2 des zweiten Bereichs 13 sind in dieser Ausführungsform rechteckförmig angeordnet. Es ist darüber hinaus auch denkbar, eine weitere Anordnung für die Transistorzellen 2 des zweiten Bereichs 13 vorzusehen, die mit Herstellungsprozessen vereinbar ist. So ist es möglich, die Transistorzellen 2 des zweiten Bereichs 13 in Form eines beliebigen Polygons, vorzugsweise in Form eines Halbkreises, oder eines einen Halbkreis annähernden Polygons, oder eines Rechtecks oder eines Quadrats, angeordnet werden.

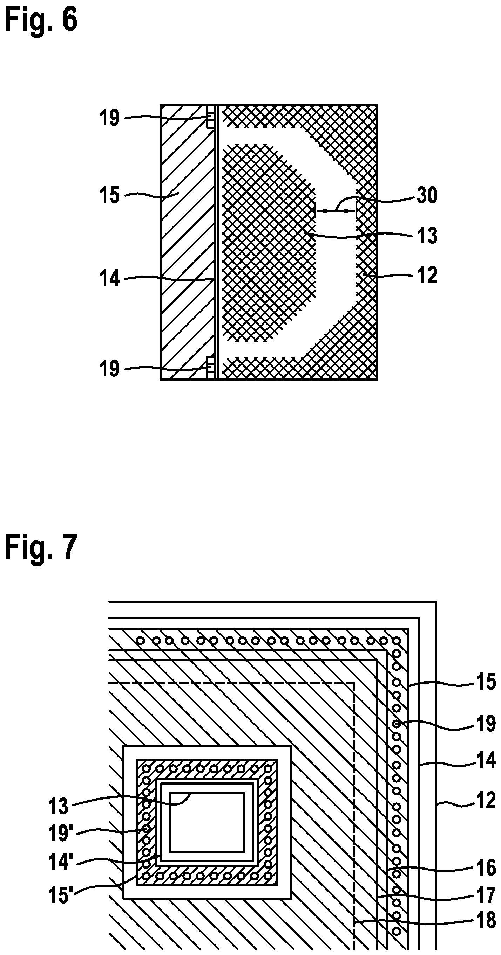

In Fig. 6 ist eine weitere Variante der Anordnung der Transistorzellen 2 des ersten Bereichs 12 und der Transistorzellen 2 des zweiten Bereichs 13 gezeigt. In dieser Ausführungsform weisen die Transistorzellen 2 des ersten Bereichs 12 und die Transistorzellen 2 des zweiten Bereichs 13 einen größeren Abstand 30 zueinander auf. Während in den bisher gezeigten Ausführungsformen der Abstand zwischen den Transistorzellen 2 des ersten Bereichs 12 und den Transistorzellen 2 des zweiten Bereichs 13 den Durchmesser der Transistorzellen 2 nur geringfügig übersteigt, kann der Abstand 30 gemäß Fig. 6 beispielsweise dem zehnfachen des Durchmessers der Transistorzellen 2 entsprechen.

In Fig. 7 ist ein Ausführungsbeispiel gezeigt, bei dem die Transistorzellen 2 des zweiten Bereichs 13 von einer zweiten Zellengebietsgrenze 14' umgeben sind, die wiederum als Doppelgrabenstruktur ausgeführt sein kann. Die Transistorzellen 2 des zweiten Bereichs 13 sind dabei nicht in die Transistorzellen 2 des ersten Bereichs 12 eingebettet beziehungsweise von diesen teilweise umgeben, sondern weit entfernt von den Transistorzellen 2 des ersten Bereichs 12 angeordnet. Eine entsprechende Öffnung des in diesem Bereich angeordneten Dickoxids erlaubt eine Verbindung zum Sensoranschluss 18.

Die Transistorzellen 2 des zweiten Bereichs 13 sind von einer weiteren p-dotierten Schicht 15' umgeben. Die Transistorzellen 2 des ersten Bereichs 12 sind außerhalb der ersten Zellengebietsgrenze 14 von der p-dotierten Schicht 15 umgeben. Die p-dotierten Schichten 15 und 15' sind voneinander getrennt. Die p-dotierte Schicht 15 wird analog zu den oben beschriebenen Ausführungsformen mittels der Kontakte 19 mit der ersten leitfähigen Schicht 16 verbunden. Die weitere p-dotierte Schicht 15' ist über weitere Kontakte 19' mit der zweiten leitfähigen Schicht 17 verbunden. Die leitenden Schichten 16 und 17 sind wiederum voneinander getrennt. In diesem Beispiel sind die dotierten Schichten 15 und 15' nahe den Kontakten 19' getrennt. Diese Lücke könnte aber auch ebenso gut anderswo zwischen 19 und 19' verlaufen. Analoges gilt für die Trennungslücke zwischen den leitenden Schichten 16 und 17.

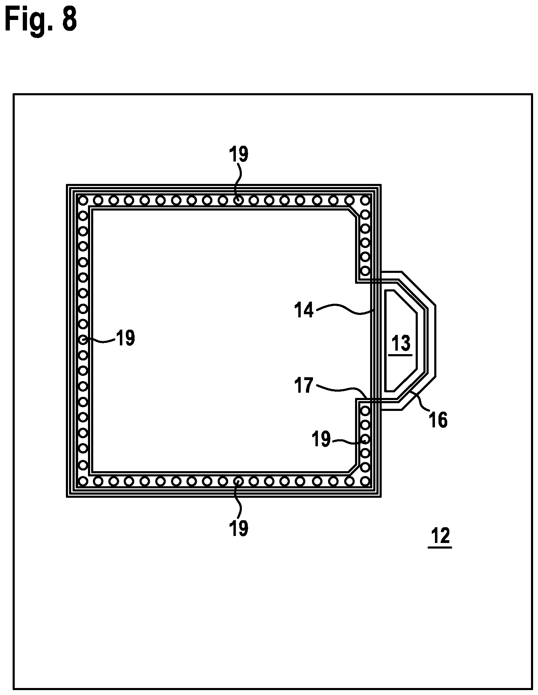

In Fig. 8 sind im Gegensatz dazu die Transistorzellen 2 des zweiten Bereichs 13 zusammen mit dem Sensoranschluss 18 in das Feld der Transistorzellen 2 des ersten Bereichs 12 eingebettet. Hierbei wird die Zellengebietsgrenze 14 so angeordnet, dass sie den Sensoranschluss 18 umgibt.

## Patentansprüche

1. Halbleiteranordnung für einen Stromsensor in einem Leistungshalbleiter, die auf einem Substrat (1) eine Mehrfachanordnung von Transistorzellen (2) mit isolierter Gate-Elektrode umfasst, deren Emitteranschlüsse (10) in einem ersten Bereich (12) über eine erste leitfähige Schicht (16) mit wenigstens einem Ausgangsanschluss (25) verbunden sind und deren Emitteranschlüsse (10) in einem zweiten Bereich (13) über eine zweite leitfähige Schicht (17) mit wenigstens einem Sensoranschluss (18) verbunden sind, der außerhalb einer ersten Zellengebietsgrenze (14) angeordnet ist, die die Transistorzellen (2) des ersten Bereichs (12) und die Transistorzellen (2) des zweiten Bereichs (13) umschließt, **dadurch gekennzeichnet, dass** zwischen den Transistorzellen (2) des zweiten Bereichs (13) und dem Sensoranschluss (18) eine zur ersten Zellengebietsgrenze (14) gehörende Grabenstruktur ausgebildet ist, an die sich in Richtung zu einem Außenrand des Substrats (1) reine mit der ersten leitfähigen Schicht (16) verbundene dotierte Schicht (15) anschließt und die dotierte Schicht (15) unterhalb des Sensoranschlusses (18) angeordnet ist.

2. Halbleiteranordnung nach Anspruch 1, bei der die Grabenstruktur als eine Doppelgrabenstruktur ausgebildet ist.

3. Halbleiteranordnung nach Anspruch 1 oder 2, bei der die Transistorzellen (2) des zweiten Bereichs (13) in Form eines Polygons, vorzugsweise in Form eines Halbkreises oder Sechsecks, eines Rechtecks oder eines Quadrats, angeordnet sind.

4. Halbleiteranordnung nach einem der Ansprüche 1 bis 3, bei der die Transistorzellen (2) des ersten Bereichs (12) die Transistorzellen (2) des zweiten Bereichs (13) wenigstens teilweise, vorzugsweise an drei Seiten, umschließen.

5. Halbleiteranordnung nach einem der Ansprüche 1 bis 3, bei der die Transistorzellen (2) des ersten Bereichs (12) die Transistorzellen (2) des zweiten Bereichs (13) und die zweite leitende Schicht (17) vollständig umschließen.

6. Halbleiteranordnung nach einem der Ansprüche 1 bis 5, bei der die Transistorzellen (2) des zweiten Bereichs (13) von den Transistorzellen (2) des ersten Bereichs (12) räumlich getrennt angeordnet sind.

7. Halbleiteranordnung nach Anspruch 6, bei der der Sensoranschluss (18) als Metallisierungs-Fläche über einer Isolationsschicht angeordnet ist, deren Schichtdicke größer als die eines Gate-Dielektrikums ist.

8. Halbleiteranordnung nach Anspruch 6 oder 7 bei der die Transistorzellen (2) des zweiten Bereichs (13) von einer zweiten Zellengebietsgrenze (14') umgeben sind.

## Claims

1. A semiconductor arrangement for a current sensor in a power semiconductor, which arrangement comprises, on a substrate (1), a multiple arrangement of transistor cells (2) with an insulated gate electrode, the emitter connections (10) of which in a first region (12) are connected to at least one output connection (25) via a first conductive layer (16) and the emitter connections (10) of which in a second region (13) are connected to at least one sensor connection (18) via a second conductive layer (17), which sensor connection is arranged outside a first cell region boundary (14) which surrounds the transistor cells (2) of the first region (12) and the transistor cells (2) of the second region (13), **characterized in that** a trench structure belonging to the first cell region boundary (14) is formed between the transistor cells (2) of the second region (13) and the sensor connection (18) and is adjoined, in the direction of an outer edge of the substrate (1), by a doped layer (15) connected to the first conductive layer (16), and the doped layer (15) is arranged below the sensor connection (18).

2. The semiconductor arrangement according to Claim 1, in which the trench structure is configured as a double trench structure.

3. The semiconductor arrangement according to Claim 1 or 2, in which the transistor cells (2) of the second region (13) are arranged in the form of a polygon, preferably in the form of a semicircle or hexagon, a rectangle or a square.

4. The semiconductor arrangement according to any one of Claims 1 to 3, in which the transistor cells (2) of the first region (12) surround the transistor cells (2) of the second region (13) at least partially, preferably on three sides.

5. The semiconductor arrangement according to any one of Claims 1 to 3, in which the transistor cells (2) of the first region (12) completely surround the transistor cells (2) of the second region (13) and the second conducting layer (17).

6. The semiconductor arrangement according to any one of Claims 1 to 5, in which the transistor cells (2) of the second region (13) are arranged spatially separated from the transistor cells (2) of the first region (12).

7. The semiconductor arrangement according to Claim 6, in which the sensor connection (18) is arranged as a metallization surface above an insulating layer, the layer thickness of which is greater than that of a gate dielectric.

8. The semiconductor arrangement according to Claim 6 or 7 in which the transistor cells (2) of the second region (13) are enclosed by a second cell region boundary (14').

## Revendications

1. Agencement de semi-conducteurs pour un capteur de courant dans un semi-conducteur de puissance, lequel comprend, sur un substrat (1), un agencement multiple de cellules de transistor (2) avec grille isolée, dont les bornes d'émetteur (10) sont reliées, dans une première zone (12), par une première couche conductrice (16) avec au moins une borne de sortie (25) et dont les bornes d'émetteur (10) sont reliées, dans une deuxième zone (13), par une deuxième couche conductrice (17) avec au moins une borne de capteur (18), laquelle est disposée hors d'une première limite de zone de cellules (14), laquelle comprend les cellules de transistor (2) de la première zone (12) et les cellules de transistor (2) de la deuxième zone (13), **caractérisé en ce que**, entre les cellules de transistor (2) de la deuxième zone (13) et la borne de capteur (18), une structure de tranchées appartenant à la première limite de zone de cellules (14) est formée, à laquelle une couche dopée (15) reliée à la première couche conductrice (16) est adjacente, en direction d'un bord extérieur du substrat (1), et **en ce que** la couche dopée (15) est disposée sous la borne de capteur (18).

2. Agencement de semi-conducteurs selon la revendication 1, sur lequel la structure de tranchées est formée comme une structure de double tranchée.

3. Agencement de semi-conducteurs selon la revendication 1 ou 2, sur lequel les cellules de transistor (2) de la deuxième zone (13) sont disposées sous la forme d'un polygone, de préférence sous la forme d'un demi-cercle ou d'un hexagone, d'un rectangle ou d'un carré.

4. Agencement de semi-conducteurs selon l'une des revendications 1 à 3, sur lequel les cellules de transistor (2) de la première zone (12) entourent, au moins partiellement, de préférence sur trois côtés, les cellules de transistor (2) de la deuxième zone (13).

5. Agencement de semi-conducteurs selon l'une des revendications 1 à 3, sur lequel les cellules de transistor (2) de la première zone (12) entourent totalement les cellules de transistor (2) de la deuxième zone (13) et la deuxième couche conductrice (17).

6. Agencement de semi-conducteurs selon l'une des revendications 1 à 5, sur lequel les cellules de transistor (2) de la deuxième zone (13) sont disposées de façon physiquement séparée des cellules de transistor (2) de la première zone (12).

7. Agencement de semi-conducteurs selon la revendication 6, sur lequel la borne de capteur (18) est disposée comme surface de métallisation sur une couche d'isolation dont l'épaisseur de couche est supérieure à celle d'un diélectrique de grille.

8. Agencement de semi-conducteurs selon l'une des revendications 6 ou 7, sur lequel les cellules de transistor (2) de la deuxième zone (13) sont entourées par une deuxième limite de zone de cellules (14').
